# EUROPEAN PATENT SPECIFICATION

(11) **EP 3 108 507 B1**
(45) Date of publication and mention of the grant of the patent: **12.05.2021**
(21) Application number: 15703202.0
(22) Date of filing: 27.01.2015
(51) Int. Cl.: H01L 29/78, H01L 21/336, H01L 29/423

(54) **SILICON CARBIDE SEMICONDUCTOR DEVICE**
SILICIUMCARBIDHALBLEITERBAUELEMENT
DISPOSITIF À SEMI-CONDUCTEURS AU CARBURE DE SILICIUM

(30) Priority: 18.02.2014 US 201414182765
(43) Date of publication of application: 28.12.2016
(73) Proprietor: General Electric Company, Schenectady, NY 12345 (US)
(72) Inventor: MCMAHON, James, Jay, Niskayuna, NY 12309 (US); STEVANOVIC, Ljubisa, Dragoljub, Niskayuna, NY 12309 (US); ARTHUR, Stephen, Daley, Niskayuna, NY 12309 (US); GORCZYCA, Thomas, Bert, Niskayuna, NY 12309 (US); BEAUPRE, Richard Alfred, Niskayuna, NY 12309 (US); STUM, Zachary, Matthew, Niskayuna, NY 12309 (US); BOLOTNIKOV, Alexander, Viktorovich, Niskayuna, NY 12309 (US)
(74) Representative: Openshaw & Co.
(86) International application number: PCT/US2015/012975
(87) International publication number: WO 2015/126575

(56) References cited:
- WO-A1-2010/073991
- JP-A- 2006 080 273
- JP-A- 2009 253 072
- US-A- 5 907 188
- US-A1- 2008 102 585
- US-A1- 2008 203 441

## Description

### BACKGROUND OF THE INVENTION

The invention relates generally to silicon carbide (SiC) semiconductor devices, and more particularly, to a gate structure for SiC semiconductor devices having a MOS (metal-oxide-semiconductor) structure, and methods for manufacturing SiC semiconductor devices.

Silicon (Si) is the most widely used semiconductor material, and has been for many years. Due to intense commercial interest and resulting research and development, silicon device technology has reached an advanced level, and in fact, many believe that silicon power devices are approaching the theoretical maximum power limit predicted for this material. Further refinements in this material are not likely to yield substantial improvements in performance, and as a result, development efforts have shifted the focus to the development of wide band gap semiconductors as replacements for silicon.

Silicon carbide (SiC) has many desirable properties for high voltage, high frequency and high temperature applications. More particularly, SiC has a wide band gap (about 3 times more than that of Si), a high breakdown field (about 10 times higher than that of Si), a high thermal conductivity (about 4 times that of Si) and a high electron saturation velocity (twice that of Si). These properties support the theory that SiC will excel over conventional power device applications, and provide devices that are capable of operating at high temperature with extremely low power losses. In addition, SiC is an advantageous semiconductor material capable of forming silicon oxide by thermal oxidation, which has been an influential basis for asserting the advantages of SiC semiconductor devices.

Among various SiC devices, a SiC MOS (metal-oxide-semiconductor) device (for example, MOSFET or IGBT) can be easily driven and simply replace currently available Si-IGBTs widely used for power switching applications. A MOSFET typically includes a gate region, a source region, a drain region, and a channel region disposed between the source region and the drain region. Typically, a gate dielectric (for example, SiO₂) is first formed on a semiconductor substrate (for example, SiC), and a gate material is then disposed on the gate dielectric to form a gate electrode.

The aforementioned applications are heavily weighted in areas requiring devices that operate for long periods of time, for example aerospace, electrical distribution, etc.; however there are factors that have made realizing a reliable SiC/SiO₂ system challenging. Thermally grown SiO₂ on SiC has a lifetime comparable to that grown on Si, however a low inversion channel mobility necessitates the use of a thin (<50nm) gate dielectric while operating at electric fields greater than 4 MV/cm to maximize channel conduction. This combination of factors results in high electric field in the gate dielectric. The generated field can be supported in the planar region of the gate dielectric, but is significantly higher at sharp corners formed at the gate electrode edges, which adversely affects the reliability of the device.

It may therefore be desirable to provide a method for fabricating a semiconductor device, more particularly a MOSFET device, with reduced electric field at the sharp corners of a gate electrode, thus provide a MOSFET device with enhanced reliability.

WO 2010/073991 is concerned with a semiconductor device and a method for producing it. JP 2009 253072 is concerned with a semiconductor device and its production process. US 2008/203441 is concerned with a SiC semiconductor device and method for manufacturing the same. US 5,907,188 is concerned with a semiconductor device with conductive oxidation preventing film and method for manufacturing the same. US 2008/102585 is concerned with a method of manufacturing a silicon carbide semiconductor device. JP 2006 080273 is concerned with a silicon carbide semiconductor apparatus and its manufacturing method.

### BRIEF DESCRIPTION OF THE INVENTION

One embodiment is directed to a semiconductor device according to claim 1.

It is herein disclosed a metal-oxide-field-effect transistor (MOSFET) device is provided. The device includes a semiconductor layer including silicon carbide, and having a first surface and a second surface. The semiconductor layer includes a drift region having a first conductivity type, a well region adjacent to the drift region and proximal to the first surface, the well region having a second conductivity type, and a source region adjacent to the well region, the source region having the first conductivity type. A gate insulating layer is disposed on a portion of the first surface of the semiconductor layer, and a gate electrode is disposed on the gate insulating layer. The device further includes an oxide disposed between the gate insulating layer and the gate electrode at a corner adjacent an edge of the gate electrode so as the gate insulating layer has a greater thickness at the corner than a thickness at a center of the layer. A dielectric layer is further disposed on the gate electrode and a portion of the first surface of the semiconductor layer.

It is herein disclosed a method for fabricating a semiconductor device. The method includes the steps of disposing a gate insulating layer on a semiconductor layer including silicon carbide, disposing a gate electrode on the gate insulating layer, and performing an oxidation process after disposing the gate electrode. The oxidation process is performed in an environment including hydrogen and oxygen in a ratio at least about 0.03:1 at a temperature less than about 950 degrees Celsius.

### DRAWINGS

These and other features, aspects, and advantages of the present invention will become better understood when the following detailed description is read with reference to the accompanying drawings, in which like characters represent like parts throughout the drawings, wherein:
FIG. 1 schematically shows cross-sectional half-cell view of a conventional MOSFET device;
FIG. 2 shows an electric field profile in a gate insulating layer of the MOSFET device of FIG. 1;
FIGS. 3-6 illustrate cross-sectional half-cell views schematically demonstrating fabrication stages of manufacturing a MOSFET device, in accordance with some embodiments of the invention;
FIG. 7 shows an electric field profile in a gate insulating layer of the MOSFET device of FIG. 6.

### DETAILED DESCRIPTION

As discussed in detail below, it is herein disclosed a method for fabricating a SiC based semiconductor device including an oxidation process step after forming a gate electrode. It is further noted that the oxidation process is performed in a manner that improves the reliability of the device without significantly affecting key electrical properties, such as threshold voltage, leakage current, and on state source-drain resistance of the device. The resulting SiC semiconductor device includes an oxide disposed between the gate insulating layer and the gate electrode at a corner adjacent an edge of the gate electrode to have a relatively thick insulation layer at the corner compared to an as-disposed gate insulating layer. As used herein, as-disposed layer refers to as-deposited layer, or as-grown layer during the fabrication process of the device without any post disposition treatment.

Approximating language, as used herein throughout the specification and claims, may be applied to modify any quantitative representation that could permissibly vary without resulting in a change in the basic function to which it is related. Accordingly, a value modified by a term or terms, such as "about", and "substantially" is not to be limited to the precise value specified. In some instances, the approximating language may correspond to the precision of an instrument for measuring the value. The terms "a", "an" and "the" include plural referents unless the context clearly dictates otherwise. As used herein, the term "and/or" includes any and all combinations of one or more of the associated listed items.

Unless defined otherwise, technical and scientific terms used herein have the same meaning as is commonly understood by one of skill in the art to which this invention belongs. The terms "first", "second", and the like, as used herein do not denote any order, quantity, or importance, but rather are used to distinguish one element from another. If ranges are disclosed, the endpoints of all ranges directed to the same component or property are inclusive and independently combinable (e.g., range of "up to about 25 weight percent, or, more specifically, about 5 weight percent to about 20 weight percent is inclusive of the endpoints and all intermediate values of the range of "about 5 weight percent to about 25 weight percent" etc.).

As used herein, the term "layer" refers to a material disposed on at least a portion of an underlying surface in a continuous or discontinuous manner. Further, the term "layer" does not necessarily mean a uniform thickness of the disposed material, and the disposed material may have a uniform or a variable thickness. Furthermore, the term "a layer" as used herein refers to a single layer or a plurality of layers, unless the context clearly dictates otherwise. In the present disclosure, when a layer is being described as "on" another layer or substrate, it is to be understood that the layers can either be directly contacting each other or have one (or more) layer or feature between the layers. Further, the term "on" describes the relative position of the layers to each other and does not necessarily mean "on top of' since the relative position above or below depends upon the orientation of the device to the viewer. Moreover, the use of "top," "bottom," "above," "below," and variations of these terms is made for convenience, and does not require any particular orientation of the components unless otherwise stated. The term "adjacent" as used herein means that the two layers are disposed contiguously and are in direct contact with each other.

It will be understood by those skilled in the art that "n-type" and "p-type" refer to the majority of charge carriers that are present in a respective semiconductor layer. For example, in n-type layers, the majority carriers are electrons, and in p-type layers, the majority carriers are holes (the absence of electrons). As used herein, "n⁺" and "n" refer to higher (greater than 1×10¹⁸ cm³) and lower (generally in the range of 5×10¹⁵ cm³ to 5×10¹⁷ cm3) doping concentrations of the dopants, respectively. Typically, p-type dopants include boron, aluminum, gallium, or any combinations thereof, and n-type dopants include nitrogen, phosphorus, or any combinations thereof, or other appropriate doping materials, as known in the art.

As described in detail later, a method for fabricating a semiconductor device is presented. The semiconductor device may be a metal-oxide-semiconductor field-effect transistor (MOSFET), an insulated-gate bipolar transistor (IGBT), or any MOS (metal-oxide-semiconductor) based semiconductor device. Although the present method and design are applicable to a wide variety of semiconductor devices, the unique features of the present invention are described with reference to a MOSFET cell or device. In an actual power MOSFET device, a number of MOSFET cells would be situated next to one-another, and share a common gate electrode and a source electrode. The method and the features of the present invention are applicable to both vertical and lateral MOSFET devices.

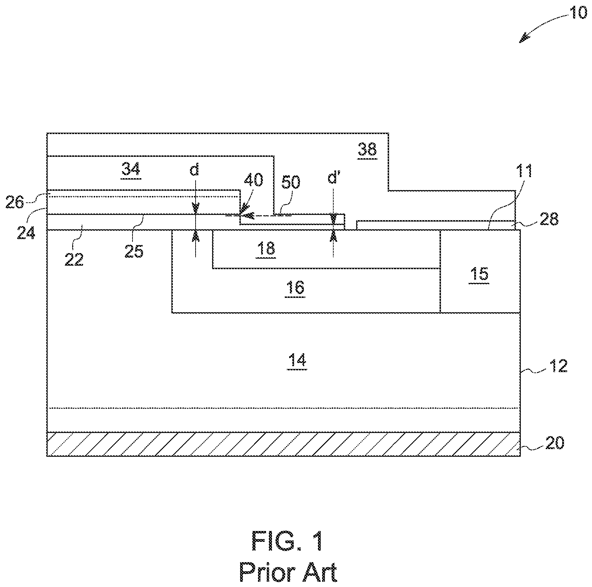

FIG. 1 is a cross sectional view of an example of a conventional SiC vertical MOSFET device 10. The device 10 generally includes a SiC layer 12 having a drift region 14 disposed thereon. A P-well region 16 is formed within a top surface 11 of the drift region 14, and an n⁺-source region 18 formed within the P-well region 16. A gate insulating layer 22 is formed on the surface 11 of the layer 12, and a gate electrode 24 is formed on the gate insulating layer 22. Typically, a polycrystalline silicon layer may be deposited and subsequently patterned and/or etched to provide a polycrystalline silicon gate electrode 24. A drain electrode 20 is often formed in contact with the semiconductor layer 12 on a bottom surface 13 that may include a substrate layer (not shown in FIG. 1). The device 10 further includes additional features such as a source electrode 38, a passivation layer 34 (for example an inter-layer dielectric), a contact region 15, and ohmic contacts 28 and 26 formed over the source region 18 and the upper portion of the polycrystalline silicon gate electrode 24.

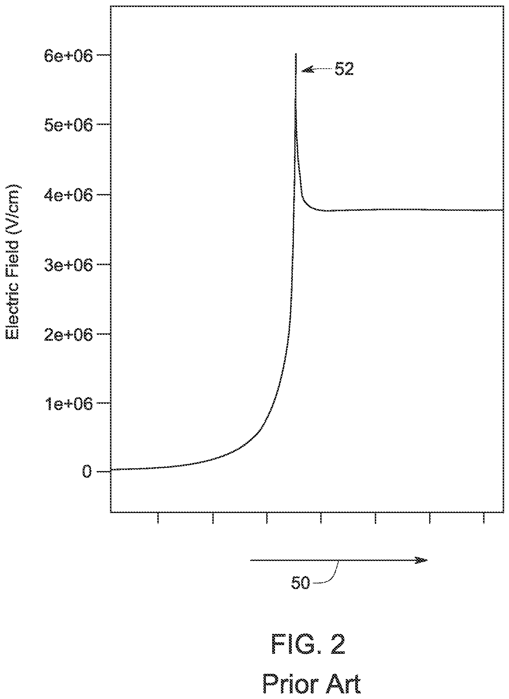

Referring FIG. 1, as known to those skilled in the art, the gate insulating layer 22 experiences an electric field under an operating bias. As discussed previously, the electric field is high near a sharp corner 40 of the gate insulating layer 22 formed adjacent an edge of a bottom surface 25 of the gate electrode 24. FIG. 2 is an electric field profile in the gate insulating layer 22 measured along a direction 50, showing a high electric field peak 52 at the corner 40.

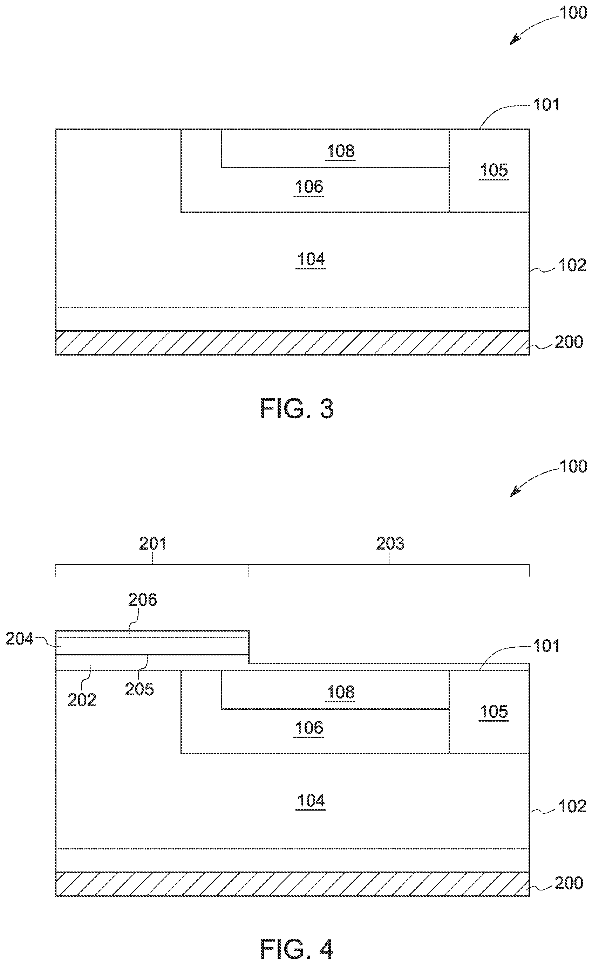

FIGS. 3-6 schematically represent fabrication stages of an illustrative vertical MOSFET device 100, according to aspects of the present invention. FIG. 3 is a cross-sectional side view of an in-process MOSFET device 100. The device 100 generally includes a semiconductor layer (may also be referred to as "wafer") 102 having a drift region 104 disposed thereon. In certain embodiments, the semiconductor layer 102 includes silicon carbide (SiC).

In the illustrated example, the device 100 has an n-doped drift region 104 and an n⁺-doped source region 108. As will be appreciated, for a device 100 having a p⁺-doped source region, the drift region 104 may be p-type doped. The n⁺-doped source region 108 is formed within a P-well region 106, proximate to a first surface 101. The P-well region 106 is typically formed through implantation of the n-doped drift region 104 by a suitable p-type dopant. As will be appreciated, the formation of P-well region 106 may involve a number of processing steps such as, masking the drift region 104 by a mask, and patterning the mask prior to the implantation in the drift region 104. The n⁺-source region 108 and a highly doped p⁺-region 105 can be formed, for example, using similar implantation steps. An annealing step is usually performed subsequent to each implantation step. A drain electrode 200 may be formed by any known method in contact with a second surface 103 of the semiconductor layer 102.

The method further includes steps of the formation of a gate insulating layer 202, and a gate electrode 204 as illustrated in FIG. 4. The gate electrode 204 is often insulated from the semiconductor layer 102 (for example, SiC wafer) by the gate insulating layer 202 (may also referred to as "gate dielectric"). The gate insulating layer 202 is first disposed on the semiconductor layer 102, followed by disposing the gate electrode 204 on the gate insulating layer 202. The gate insulating layer 202 may often include silicon dioxide (SiO₂), silicon nitride, or combinations thereof. Other suitable materials may include tantalum oxide (Ta₂O₅), alumina (Al₂O₃), zirconium oxide (ZrO₂), hafnium oxide (HfO₂) or other glass-forming materials. Usually, the gate insulating layer 202 includes an oxide and therefore referred to as "gate oxide layer." In certain embodiments, the gate oxide layer 202 includes silicon dioxide (SiO₂). In some embodiments, a thickness (d) of the gate insulating layer 202 may be in a range of about 20 nanometers to about 200 nanometers.

The formation of the gate insulating layer 202, in one instance, may be performed by any known method. In certain instances, the gate oxide layer 202 may be provided by oxidizing the semiconductor layer 102 (for example, SiC wafer), at a high temperature, for example, greater than about 1100 degrees Celsius. The oxidation can be carried out by any known method, including, for example wet oxidation or dry oxidation. The gate insulating layer 202 may desirably be annealed by any method known to those of skilled in the art.

In a further step, the gate electrode 204 is disposed on a first portion 201 of the gate insulating layer 202. The gate electrode 204 includes polycrystalline silicon, and a metal-containing layer including a metal silicide. A polycrystalline silicon layer is deposited on the gate insulating layer 202, and subsequently patterned and /or etched to provide a polycrystalline silicon gate electrode 204. The polycrystalline silicon layer may be doped, for example, p⁺-doped in order to increase the conductivity thereof. Usually, the thickness of the polycrystalline silicon layer may be less than about 2 microns. In certain instances, the thickness of the polycrystalline silicon layer can be, for example, in a range of about 0.1 micron to about 1 micron.

A metal-containing layer 206 is disposed on the polycrystalline silicon layer 204. The metal-containing layer 206 may include a metal selected from the group consisting of tantalum, nickel, molybdenum, cobalt, titanium, tungsten, niobium, hafnium, zirconium, vanadium, aluminum, chromium, and platinum. The metal-containing layer 206 includes a metal silicide, for example tantalum silicide. The thickness of the metal-containing layer 206 may range from about 10 nm to about 500 nm. In some instances, the metal-containing layer 206 may be annealed.

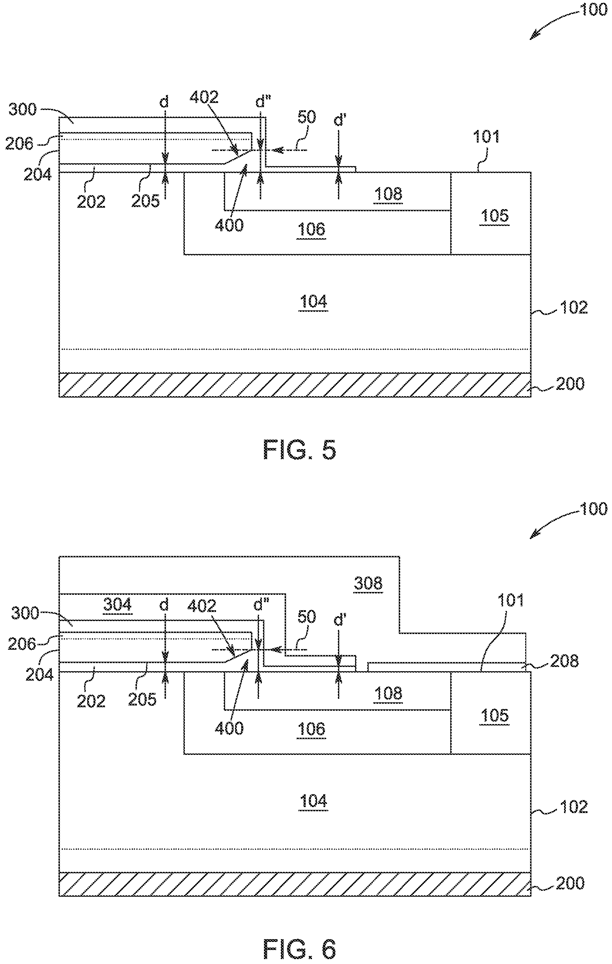

As mentioned, an etching step is performed to remove the gate electrode materials from undesirable portions of the device 100, for example a second portion 203 of the gate insulating layer 202, drift region 104 etc. The etching step removes some of the material from a surface of the gate insulating layer 202 during the process, leaving the second portion 203 of the gate insulating layer 202 with reduced thickness (d'), d' < d as shown in FIG. 5. It is herein disclosed, but not claimed, that the etching step may fully remove the second portion of the gate insulating layer 202.

As mentioned previously, the method further includes a step of performing an oxidation process step. The oxidation process is performed after forming the gate electrode 204, and in certain embodiments, after forming the metal-containing layer 206. In some other embodiments, the oxidation process may be performed after the deposition of an inter-layer dielectric (ILD) 304 (described below). The oxidation process is carried out in an environment including hydrogen and oxygen, at a temperature less than about 950 degrees Celsius. As known to those skilled in the art, an oxidation process that is carried out in presence of hydrogen and oxygen is usually referred to as "wet oxidation." In wet oxidation, the gaseous mixture of hydrogen and oxygen forms pyrogenic steam, which oxidizes the gate electrode 204. The oxidizing environment may also include other inert gases such as nitrogen, argon etc. Although combinations of multiple gases may be utilized, consideration should be given to process design, and if the use of multiple carrier gases provides no or negligible advantage, preference in some cases may be given to the utilization of only hydrogen and oxygen in the gaseous mixture.

Also, the concentration of each gas within the gaseous mixture will depend upon the gases chosen. Typically the oxygen concentration will drive the oxidation process, and can be chosen to achieve a desired oxidation rate, with consideration given to the other oxidation process parameters. However, in wet oxidation, the concentration of both hydrogen and oxygen may affect the oxidation rate, and quality of a resulting oxide layer. According to some embodiments of the invention, the oxidation process is carried out in an environment including hydrogen and oxygen in a ratio at least about 0.03:1 at a temperature less than about 950 degrees Celsius. In some embodiments, the ratio of hydrogen and oxygen in the oxidizing environment may range from about 1:1 to about 3:1. In certain embodiments, the ratio of hydrogen and oxygen may range from about 1.5:1 to about 2:1.

Generally, the oxidation process involves heating the wafer in a chamber such as a furnace to a desired temperature, and then introducing the gases or the gaseous mixture into the chamber. Alternatively, the desirable gases or the gaseous mixture can be introduced to the chamber, and then the chamber can subsequently be heated to the desired temperature. In some instances, the gaseous mixture containing hydrogen and oxygen in a desired ratio may be provided into the chamber. In some other embodiments, predetermined amounts of hydrogen and oxygen may be individually supplied into the chamber to achieve a desired ratio inside the chamber.

As will be appreciated by one of ordinary skill in the art, the oxidation process may include one or more oxidation process sub-steps, where oxidation may be carried out by, for example, using a different temperature or pressure and/or a different hydrogen-to-oxygen ratio in the oxidizing environment in one or more of the oxidation process sub-steps. The sub-steps may also include annealing steps at high temperature. Though embodiments of the invention describe the oxidation process carried out in an oxidizing environment containing hydrogen and oxygen, replacement of hydrogen in the oxidizing environment in one or more of the oxidation process sub-step with an isotope of hydrogen, for example deuterium, is within the scope of the invention.

During the oxidation process, an oxide layer 300 grows on top and on the sides of the gate electrode 204 as depicted in FIG. 5. It has been further observed that by performing the oxidation process step according to the aspects of the invention, the sharp corner 40 (FIG. 1) is converted into an oxide, and the oxide exists at a bottom surface 205 of the gate electrode 204 near an edge 402. As a result, the thickness of the insulating material below the edge 402 of the gate electrode 204 increases to d"; d" > d. In other words, the thickness (d") of the gate insulating layer 202 at a corner 400 adjacent the edge 402 is greater than the thickness (d) at the center of the layer 202. The gate insulating layer 202 is more than about 1 percent thick at the corner adjacent the edge 402 than at the center. In some instances, an increase in the thickness of the gate insulating layer 202 at the corner 400 adjacent the edge 402 is in a range from about 1 percent to about 500 percent. In certain instances, an increase in the thickness is in a range from about 10 percent to about 300 percent. In some embodiments, the geometry of the corner is such that an electric field at the corner is less than or equal to an electric field in rest of the portion of the gate insulation layer.

The oxide layer 300 at the top surface of the gate electrode is often removed, for example by etching. It has been found that etch rate for the oxide layer 300 is much lower than the etch rate for a dielectric layer 304 (for example PSG layer), indicating that oxide layer 30 includes a high quality oxide.

The oxidation process may be carried out for any desired time period, and is typically carried out for a sufficient amount of time to increase the thickness of the gate insulating layer 202 at the corner and provide the oxide layer 300 of a desired thickness. The oxide layer 300 may have a thickness in a range from about 20 nanometers to about 500 nanometers, and such thicknesses typically may be provided, depending on the particular oxidation parameters, in an oxidation time from about 1 second to about 30 minutes. In some instances, the oxidation time may be longer than 30 minutes, especially in cases when the oxidation process is performed at low temperatures.

FIG. 6 shows a complete MOSFET device 100, more specifically a SiC MOSFET device. Once the oxidation has been carried out, the wafer is further processed to provide additional features, such as a source contact 208, a source electrode 308 and a passivation layer 304. The passivation layer 304 typically includes a dielectric material, sometimes referred to as an inter-layer dielectric (ILD). The layer 304 is generally disposed to cover the gate electrode 204. In some embodiments, an inter-layer dielectric 304 may be disposed on the gate electrode 206 after performing the oxidation process. In some other embodiments, the oxidation process may be performed after disposing the dielectric layer 304. In certain instances, the dielectric layer 304 may comprise a material including phosphorous silicate glass (PSG).

The source electrode 308 generally formed of a metal (for example, aluminum) can be further disposed over the dielectric layer 304. The source electrode 308 is in electrical contact with the source region 108 and the P-well region 106 through the source contact 208. In some embodiments, multiple metallic layers may be disposed. The metallic layers may include aluminum, nickel, molybdenum, tungsten, gold, copper, tantalum, titanium, platinum or combinations therefore.

In the fabrication of a semiconductor device such as a MOSFET device 100 discussed above with reference to FIGS. 3-6, the formation/deposition of various regions and layers may include one or more sub-steps including masking, patterning, etching, or annealing as known to those skilled in the art and required for the formation of device 100.

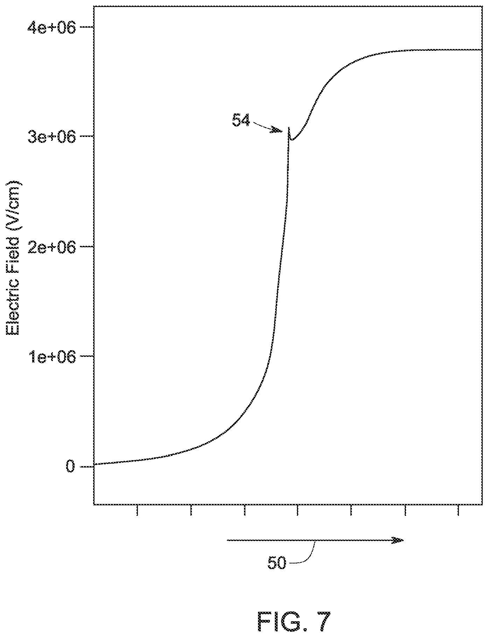

FIG. 7 shows an electric field profile in the gate insulating layer 202 of FIG. 6 measured along the direction 50. It is clear that an electric field value 54 at the corner near the edge 402 is much lower than the electric field value (FIG. 2) at the corner 40 in device 10 of FIG. 1. The oxidation process performed according to the aspects of the invention prevents electric fields from concentrating at corners of the gate insulating layer formed adjacent the gate electrode edges. The resulting MOSFET devices thus formed may have a reduced electric field at the corners, and exhibit enhanced reliability.

As mentioned earlier, it may further be desirable to carry out the oxidation process in the oxidizing environment containing hydrogen and oxygen at a temperature less than about 950 degrees Celsius. Table 1 shows normalized values of threshold voltages of a comparative MOSFET device and an experimental MOSFET device with respect to a baseline MOSFET device. The comparative and experimental devices were fabricated with similar process steps as performed for the fabrication of the baseline MOSFET device except the oxidation process step performed after disposing the gate electrode. The comparative device was fabricated by using an oxidation process step carried out at about 950 degrees Celsius, and the experimental device was fabricated by using an oxidation process step carried out at about 850 degrees Celsius. It has been observed that the oxidation process carried out at about 950 degrees Celsius or even higher may provide a MOSFET device (for example, comparative MOSFET device) that has reduced threshold voltage as compared to the threshold voltage of the baseline device, which reflects degrading performance of the comparative device. The oxidation process according to the present method may thus be advantageously carried out at lower temperatures, for example, lower than about 900 degrees Celsius. In some instances, the oxidation process may be carried out at a temperature between about 700 degrees Celsius and about 900 degrees Celsius. Table 1 clearly shows that the oxidation process carried out at about 850 degrees Celsius provides the experimental MOSFET device with desirable threshold voltage. In some instances, it may also be possible to perform the oxidation process even at lower temperatures by using high pressure oxidation.

**Table 1**

| **Sample device** | **Normalized Vₜₕ (arbitrary units)** |
|---|---|
| Baseline MOSFET device | 1.0 |
| Comparative MOSFET device | 0.715 |
| Experimental MOSFET device | 1.01 |

It has been observed that performing the oxidation process after the formation of the gate electrode results in a semiconductor device with improved reliability. Failure data from accelerated life testing of experimental MOSFET device samples (that involve the described oxidation process step after the formation of the gate electrodes during the fabrication process of the sample devices, for example FIG. 6) compared to baseline MOSFET device samples (which do not involve the described oxidation process after forming the gate electrodes during the fabrication process of the sample devices, for example FIG. 1) were analyzed by using a 3-competing-failure-mode analysis (t₀, extrinsic, and intrinsic failure modes), producing a prediction of failure rate versus time. The predicted in-field failure rate was then extracted from a plot at a value where early failures were consumed (by a presumed burn-in/screening test) and scaled in billions of device-operation-hours, or Failures in time (FITs). Experimental samples showed about 50% to about 500% improvement in FIT rates as compared to the baseline samples.

The shape and dimensions (for example, thickness) of several layers, regions, and components discussed above with reference to FIGS. 1, 3-6 are only illustrative for the understanding of the MOSFET structure; and are not meant to limit the scope of the invention. The exact shape, dimensions, and position of regions and components (e.g., source region, drain region etc.) can vary to some degree.

The appended claims are intended to claim the invention as broadly as it has been conceived and the examples herein presented are illustrative of selected embodiments from a manifold of all possible embodiments. Accordingly, it is the Applicants' intention that the appended claims are not to be limited by the choice of examples utilized to illustrate features of the present invention. As used in the claims, the word "comprises" and its grammatical variants logically also subtend and include phrases of varying and differing extent such as for example, but not limited thereto, "consisting essentially of' and "consisting of." Where necessary, ranges have been supplied; those ranges are inclusive of all sub-ranges there between. It is to be expected that variations in these ranges will suggest themselves to a practitioner having ordinary skill in the art and where not already dedicated to the public, those variations should where possible be construed to be covered by the appended claims,

## Claims

1. A semiconductor device (100), comprising:
a semiconductor layer (102) comprising silicon carbide having a first surface (101) and a second surface;
a gate insulating layer (202) having a first thickness (d) at a center of the insulating layer (202) and being disposed on a portion of the first surface (101) of the semiconductor layer (102),
a gate electrode (204) disposed on the gate insulating layer (202), wherein the gate electrode (204) comprises a polycrystalline silicon layer (204) deposited on the gate insulating layer (202) and a metal-containing layer (206), wherein the metal-containing layer (206) includes a metal silicide, disposed on the polycrystalline silicon layer (204); and
an oxide disposed between the gate insulating layer (202) and the gate electrode (204) at a corner (400) adjacent an edge (402) of the gate electrode (204) so as the gate insulating layer (202) and the oxide layer combined have a greater thickness at the corner (400) adjacent the edge (402) of the gate electrode (204) than a said first thickness (d) of the insulating layer (202);
wherein the oxide is formed by converting a lower sharp corner (40) of said polycrystalline silicon layer by performing an oxidation process, wherein the oxidation process is performed in an environment comprising hydrogen and oxygen , and
wherein a second portion of the gate insulating layer (202) has a second thickness (d') thinner than the first thickness (d), said second portion of the gate insulating layer extending laterally from said edge (402) in a direction outwards from said gate electrode (204) on said first surface (101), said second portion of the gate insulating layer (202) being formed by removing some of the material from a surface of the gate insulating layer (202) by etching.

2. The semiconductor device according to claim 1, the device being a metal-oxide field-effect transistor, MOSFET, device, the semiconductor layer (102) comprising:
a drift region (104) having a first conductivity type;
a well region (106) adjacent to the drift region and proximal to the first surface, the well region having a second conductivity type; and
a source region (108) adjacent to the well region, the source region having the first conductivity type.

3. A device according to claim 1 or 2, wherein the gate insulating layer (202) is more than 1 percent thicker at the corner (400) adjacent the edge (402) than at a center of the layer (202).

4. A device according to claim 1 or 2, wherein the gate insulating layer (202) is from 1 percent to 500 percent thicker at the corner (400) adjacent the edge (402) than at a center of the layer (202).

5. A device according to any of claims 1 to 4, further comprising a dielectric layer (304) disposed on the gate electrode (204).

## Patentansprüche

1. Halbleitervorrichtung (100), die Folgendes umfasst:
eine Halbleiterschicht (102), die Siliziumkarbid umfasst, die eine erste Oberfläche (101) und eine zweite Oberfläche aufweist;
eine Gate-Isolierschicht (202), die eine erste Dicke (d) in einer Mitte der Isolierschicht (202) aufweist und auf einem Abschnitt der ersten Oberfläche (101) der Halbleiterschicht (102) angeordnet ist, eine Gate-Elektrode (204), die auf der Gate-Isolierschicht (202) angeordnet ist, wobei die Gate-Elektrode (204) eine polykristalline Siliziumschicht (204), die auf der Gate-Isolierschicht (202) abgeschieden ist, und eine metallhaltige Schicht (206) umfasst, wobei die metallhaltige Schicht (206) ein Metallsilizid einschließt, das auf der polykristallinen Siliziumschicht (204) angeordnet ist; und
ein Oxid, das zwischen der Gate-Isolierschicht (202) und der Gate-Elektrode (204) an einer Ecke (400) angrenzend an einen Rand (402) der Gate-Elektrode (204) angeordnet ist, so dass die Gate-Isolierschicht (202) und die Oxidschicht kombiniert an der Ecke (400) angrenzend an den Rand (402) der Gate-Elektrode (204) eine größere Dicke als die erste Dicke (d) der Isolierschicht (202) aufweisen;
wobei das Oxid durch Umwandeln einer unteren scharfen Ecke (40) der polykristallinen Siliziumschicht durch Durchführen eines Oxidationsvorgangs ausgebildet wird, wobei der Oxidationsvorgang in einer Umgebung durchgeführt wird, die Wasserstoff und Sauerstoff umfasst, und wobei ein zweiter Abschnitt der Gate-Isolierschicht (202) eine zweite Dicke (d') aufweist, die dünner als die erste Dicke (d) ist, wobei sich der zweite Abschnitt der Gate-Isolierschicht seitlich von dem Rand (402) in einer Richtung nach außen von der Gate-Elektrode (204) auf der ersten Oberfläche (101) erstreckt, wobei der zweite Abschnitt der Gate-Isolierschicht (202) durch Entfernen eines Teils des Materials von einer Oberfläche der Gate-Isolierschicht (202) durch Ätzen ausgebildet wird.

2. Halbleitervorrichtung nach Anspruch 1, wobei die Vorrichtung eine Metalloxid-Feldeffekttransistor(*metal*-*oxide field-effect transistor-* MOSFET)-Vorrichtung ist, wobei die Halbleiterschicht (102) Folgendes umfasst:
einen Driftbereich (104), der eine erste Leitfähigkeitsart aufweist;
einen Senkenbereich (106) angrenzend an den Driftbereich und proximal zu der ersten Oberfläche, wobei der Senkenbereich eine zweite Leitfähigkeitsart aufweist; und
einen Source-Bereich (108) angrenzend an den Senkenbereich, wobei der Source-Bereich die erste Leitfähigkeitsart aufweist.

3. Vorrichtung nach Anspruch 1 oder 2, wobei die Gate-Isolierschicht (202) an der Ecke (400) angrenzend an den Rand (402) mehr als 1 Prozent dicker als in einer Mitte der Schicht (202) ist.

4. Vorrichtung nach Anspruch 1 oder 2, wobei die Gate-Isolierschicht (202) an der Ecke (400) angrenzend an den Rand (402) 1 bis 500 Prozent dicker als in einer Mitte der Schicht (202) ist.

5. Vorrichtung nach einem der Ansprüche 1 bis 4, die ferner eine dielektrische Schicht (304) umfasst, die auf der Gate-Elektrode (204) angeordnet ist.

## Revendications

1. Dispositif à semi-conducteur (100), comprenant :
une couche semi-conductrice (102) comprenant du carbure de silicium et comportant une première surface (101) et une seconde surface ;
une couche isolante (202) de grille présentant une première épaisseur (d) au centre de la couche isolante (202) et étant disposée sur une partie de la première surface (101) de la couche semi-conductrice (102), une électrode de grille (204) étant disposée sur la couche isolante (202) de grille, dans lequel l'électrode de grille (204) comprend une couche de silicium polycristallin (204) déposée sur la couche isolante (202) de grille et une couche contenant du métal (206), dans lequel la couche contenant du métal (206) comprend un siliciure métallique disposé sur la couche de silicium polycristallin (204) ; et
un oxyde disposé entre la couche isolante (202) de grille et l'électrode de grille (204) au niveau d'un coin (400) adjacent à un bord (402) de l'électrode de grille (204) de telle sorte que la couche isolante (202) de grille et la couche d'oxyde combinées présentent une épaisseur supérieure, au niveau du coin (400) adjacent au bord (402) de l'électrode de grille (204), à une première épaisseur (d) de la couche isolante (202) ;
dans lequel l'oxyde est formé par transformation d'un coin aigu inférieur (40) de ladite couche de silicium polycristallin par réalisation d'un processus d'oxydation, dans lequel le processus d'oxydation est réalisé dans un environnement comprenant de l'hydrogène et de l'oxygène, et dans lequel une seconde partie de la couche isolante (202) de grille présente une seconde épaisseur (d') inférieure à la première épaisseur (d), ladite seconde partie de la couche isolante de grille s'étendant latéralement à partir dudit bord (402) dans une direction extérieure par rapport à ladite électrode de grille (204) sur ladite première surface (101), ladite seconde partie de la couche isolante (202) de grille étant formée par enlèvement, par gravure, d'une partie de la matière d'une surface de la couche isolante (202) de grille.

2. Dispositif à semi-conducteur selon la revendication 1, ledit dispositif étant un dispositif de transistor à effet de champ métal-oxyde, MOSFET, la couche semi-conductrice (102) comprenant :
une zone de dérive (104) présentant un premier type de conductivité ;
une zone de puits (106) adjacente à la zone de dérive et proximale à la première surface, la zone de puits présentant un second type de conductivité ; et
une zone de source (108) adjacente à la zone de puits, la zone de source présentant le premier type de conductivité.

3. Dispositif selon la revendication 1 ou 2, dans lequel la couche isolante (202) de grille est plus de 1 % plus épaisse au niveau du coin (400) adjacent au bord (402) qu'au centre de la couche (202).

4. Dispositif selon la revendication 1 ou 2, dans lequel la couche isolante (202) de grille est de 1 % à 500 % plus épaisse au niveau du coin (400) adjacent au bord (402) qu'au centre de la couche (202).

5. Dispositif selon l'une quelconque des revendications 1 à 4, comprenant en outre une couche diélectrique (304) disposée sur l'électrode de grille (204).
